(19) Europäisches Patentamt
European Patent Office
Office européen des brevets

(11) Veröffentlichungsnummer: **0 085 305**
**B1**

(12) # EUROPÄISCHE PATENTSCHRIFT

(45) Veröffentlichungstag der Patentschrift: **03.09.86**

(51) Int. Cl.⁴: **C 08 F 2/50,** G 03 C 1/68

(21) Anmeldenummer: **83100157.3**

(22) Anmeldetag: **11.01.83**

(54) **Verwendung von Hydroxyalkylphenonen als Initiatoren für die Strahlungshärtung wässriger Prepolymerdispersionen.**

(30) Priorität: **30.01.82 DE 3203096**

(43) Veröffentlichungstag der Anmeldung: **10.08.83 Patentblatt 83/32**

(45) Bekanntmachung des Hinweises auf die Patenterteilung: **03.09.86 Patentblatt 86/36**

(84) Benannte Vertragsstaaten: **AT BE CH DE FR GB IT LI NL SE**

(56) Entgegenhaltungen:
**DE-A-2 808 459**
**FR-A-2 391 183**
**US-A-2 367 661**

**Die Akte enthält technische Angaben, die nach dem Eingang der Anmeldung eingereicht wurden und die nicht in dieser Patentschrift enthalten sind.**

(73) Patentinhaber: **Merck Patent Gesellschaft mit beschränkter Haftung, Frankfurter Strasse 250, D-6100 Darmstadt (DE)**

(72) Erfinder: **Herz, Claus P., Dr., Berghalde 20, D-6900 Heidelberg 1 (DE)**
Erfinder: **Ohngemach, Jörg, Dr., Taubenstrasse 6, D-6107 Reinheim 5 (DE)**
Erfinder: **Stahlecker, Otto, Frankfurter Landstrasse 36, D-6100 Darmstadt (DE)**

**EP 0 085 305 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

LIBER, STOCKHOLM 1986

**Description**

Photochemisch initiierte Polymerisationsreaktionen haben in der Technik große Bedeutung erlangt, insbesondere wenn es um eine schnelle Härtung von dünnen Schichten geht, wie z.B. bei der Härtung von Lack- und Harzüberzügen auf Papier, Metall und Kunststoff. Dabei zeichnet sich die Strahlungshärtung in Gegenwart von Photoinitiatoren gegenüber konventionellen Methoden zum Härten von Beschichtungen durch Rohstoff- und Energieersparnis, geringe thermische Belastung des Untergrundes und insbesondere eine hohe Härtungsgeschwindigkeit aus. Als umweltfreundliche Beschichtungsmittel haben zudem in neuerer Zeit wäßrige, von flüchtigen Bestsandteilen freie Systeme an Interesse gewonnen, insbesondere weil damit eine Verschmutzung der Umwelt durch organische Lösungsmittel und Monomere vermieden oder zumindest verringert, die Feuergefährlichkeit im Umgang mit Beschichtungs-, Imprägnierungs- und Klebstoffzubereitungen gemindert sowie die hohen Kosten für organische Lösungsmittel eingespart werden können.

Solche wäßrigen Beschichtungsmittel stellen jedoch besondere Anforderungen an den verwendeten Photoinitiator, insbesondere an die Löslichkeit des Initiators in der Reaktionsmischung, die Dunkellagerstabilität des mit dem Initiator versetzten Reaktionssystems, die chemische Stabilität des Initiators in wäßrigen Systemen und sein Verhalten bei der Entfernung des Wassers aus diesen wäßrigen Systemen sowie vor allem an seine Reaktivität, die die Geschwindigkeit der Härtung bestimmt.

Als Photoinitiatoren, die sich zur Verwendung in strahlungshärtbaren wäßrigen Prepolymerdispersionen eignen, sind bisher hauptsächlich Benzophenon-Derivate, Benzoinether, Benzilmonoketale, Anthrachinone, Thioxanthone bzw. deren Derivate sowie andere aromatische Ketone genannt worden. Diesen Photoinitiatoren haften jedoch eine Reihe von Nachteilen an. Hierzu gehören u.a. unzureichende Löslichkeit in den wäßrigen Prepolymersystemen, zu geringe Stabilität der mit diesen Initiatoren versetzten strahlungshärtbaren Systeme, Vergilbung der gehärteten Polymerisate durch Reste des Initiators oder daraus während der photochemischen Reaktion entstandene Zerfallsprodukte. Insbesondere besitzen diese Photoinitiatoren jedoch eine unzureichende Reaktivität bei der Strahlungshärtung dieser speziellen Systeme, was relativ lange Härtungszeiten erforderlich macht.

Weiterhin wurde auch bereits 1-Phenyl-2-hydroxy-2-methyl-propanon-(1) aus der Gruppe der Hydroxyalkylphenone als Photoinitiator für spezielle strahlungshärtbare wäßrige Prepolymersysteme (vgl. EP-OS 33 896) empfohlen. Diese Verbindung, die sich als Initiator in nicht-wäßrigen photopolymerisierbaren Systemen besonders bewährt hat und gegenüber anderen Initiatoren bedeutende Vorteile, wie gute Einarbeitbarkeit in die photopolymerisierbaren Systeme, gute Dunkellager- sowie chemische Stabilität und eine gesteigerte photoinitiierende Wirksamkeit besitzt, zeigt jedoch bei der Strahlungshärtung wäßriger Beschichtungsmittel Nachteile. So muß sie in wäßrigen Systemen in relativ hohen Mengen, insbesondere bei der Härtung von dünnen Schichten, eingesetzt werden und weist Zudem in diesen speziellen strahlungshärtbaren Prepolymersystemen nur eine ungenügende Reaktivität bei der Initiierung der Strahlungshärtung auf, was relativ lange Härtungszeiten erforderlich macht und zu einer nicht optimalen Ausnutzung der industriellen Bestrahlungsanlagen führt.

Es bestand daher die Aufgabe, Initiatoren für die Strahlungshärtung wäßriger Prepolymerdispersionen zu finden die physiologisch unbedenklich sind, in die wäßrigen Systeme gut einarbeitbar sind, in diesen eine möglichst hohe Löslichkeit sowie chemische Stabilität aufweisen, die im Gemisch mit den anderen Reaktionspartnern eine ausreichende Dunkellagerstabilität besitzen, die selbst oder durch ihre Folgeprodukte keine Vergilbung der Reaktionsprodukte verursachen, die bei den mit ihnen erhaltenen Beschichtungen eine wesentlich geringere Oberflächenklebrigkeit verursachen und die dabei eine größtmögliche Reaktivität in ihrem Vermögen, die Härtung solcher strahlungshärtbarer Systeme zu initiieren, zeigen und bereits in geringen Einsatzkonzentrationen wirksam sind.

Es wurde gefunden, daß Hydroxyalkylphenone der nachstehenden Formel I sich als Initiatoren für die Strahlungshärtung wäßriger Prepolymerdispersionen eignen. Diese Verbindungen besitzen die geschilderten Nachteile nicht oder in wesentlich geringerem Maße als die bisher bei der Strahlungshärtung von wäßrigen Systemen verwendeten Initiatoren. Sie zeigen insbesondere eine gute Stabilität in wäßrigen Systemen sowie bei der Entfernung des Wassers aus diesen Systemen und eine beträchtlich gesteigerte Reaktivität in ihrem Vermögen, die Härtung wäßriger strahlungshärtbarer Systeme zu initiieren.

Gegenstand der Erfindung ist somit die Verwendung von Hydroxyalkylphenonen der allgemeinen Formel I

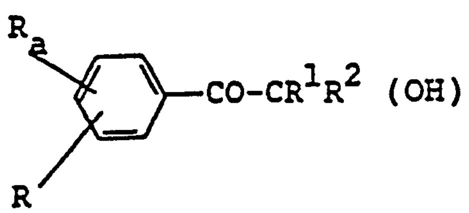

(I)

worin

R Wasserstoff, Halogen, Alkyl mit 1 bis 18 C-Atomen, Alkoxy mit 1 bis 4 C-Atomen oder

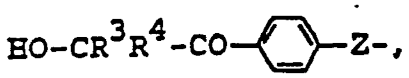

$R_a$ Wasserstoff, Halogen oder Alkyl mit 1 bis 4 C-Atomen,

$R^1$ und $R^2$ a) jeweils Alkyl mit bis zu 14, zusammen 4 bis 16 C-Atomen oder gemeinsam Alkylen mit 4 bis 8 C-Atomen, falls R Wasserstoff, Halogen, Alkyl mit 1 bis 6 C-Atomen oder Alkoxy mit 1 bis 4 C-Atomen bedeutet,

b) jeweils Alkyl mit 1 bis 6 C-Atomen oder gemeinsam Alkylen mit 2 bis 8 C-Atomen, falls R Alkyl mit 3 bis 18 C-Atomen oder

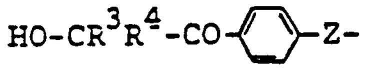 bedeutet,

bedeutet,

$R^3$ und $R^4$ jeweils Alkyl mit 1 bis 6 C-Atomen oder gemeinsam Alkylen mit 2 bis 8 C-Atomen und

Z -CO-, $-CH_2$-, -O- oder -S

bedeuten,

als Initiatoren für die Photopolymerisation ethylenischungesättigter Verbindungen, die dadurch gekennzeichnet ist, daß die Initiatoren vor der Photopolymerisation in wäßrige Prepolymerdispersionen eingearbeitet werden.

Gegenstand der Erfindung ist auch ein Verfahren zur Photopolymerisation von ethylenisch ungesättigten Verbindungen, das dadurch gekennzeichnet ist, daß man die Initiatoren der vorstehenden allgemeinen Formel I in wäßrige Prepolymerdispersionen einarbeitet und nach Entfernung des Wassers die Polymerisation auslöst.

Die Hydroxyalkylphenone der allgemeinen Formel I, Verfahren zu ihrer Herstellung und ihre Verwendung als Initiatoren für die Photopolymerisation ungesättigter Verbindungen sind bereits aus der DE-OS 27 22 264, der EP-OS 3002 sowie der DE-OS 30 08 411 bekannt. Auf ihre besondere Eignung zur Initiierung der Strahlungshärtung wäßriger Prepolymerdispersionen jedoch finden sich hier keinerlei Hinweise. Insbesondere konnte diesen Druckschriften nicht entnommen werden, daß aus der Fülle der dort genannten Verbindungen gerade die speziellen Hydroxyalkylphenone der allgemeinen Formel I so besonders vorteilhafte Eigenschaften bei einer Verwendung in wäßrigen Systemen aufweisen.

In der allgemeinen Formel I bedeutet R, falls $R^1$ und $R^2$ jeweils für Alkyl mit bis zu 14, zusammen 4 bis 16 C-Atomen oder gemeinsam für Alkylen mit 4 bis 8 C-Atomen stehen, Wasserstoff, Halogen, unverzweigtes oder verzweigtes Alkyl mit 1 bis 6 C-Atomen oder Alkoxy mit 1 bis 4 C-Atomen; vorzugsweise bedeutet R Wasserstoff, Chlor, Methyl, Ethyl, i-Propyl, tert. Butyl, Methoxy. Falls $R^1$ und $R^2$ jeweils Alkyl mit 1 bis 6 C-Atomen oder gemeinsam Alkylen mit 2 bis 8 C-Atomen bedeuten, steht R für unverzweigtes oder verzweigtes Alkyl mit 3 bis 18 C-Atomen oder

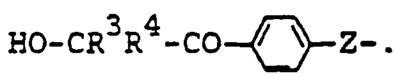

Bevorzugt bedeutet R hierbei i-Propyl, tert. Butyl, Hexyl, Octyl, 2-Ethylhexyl, Decyl, Dodecyl, Tetradecyl, Hexadecyl, Octadecyl oder

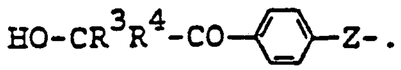

R befindet sich vorzugsweise in 4-Stellung.

$R_a$ bedeutet Wasserstoff, Halogen oder unverzweigtes oder verzweigtes Alkyl mit 1 bis 4 C-Atomen, vorzugsweise Wasserstoff, Chlor oder Methyl. Der Substituent steht in der Regel in 2- oder 3-Stellung.

Falls R für Wasserstoff, Halogen, Alkyl mit 1 bis 6 C-Atomen oder Alkoxy mit 1 bis 4 C-Atomen steht, bedeuten $R^1$ und $R^2$ jeweils unverzweigtes oder verzweigtes Alkyl mit bis zu 14, zusammen 4 bis 16 C-Atomen oder gemeinsam unverzweigtes oder verzweigtes Alkylen mit 4 bis 8 C-Atomen. Bevorzugt sind unverzweigte Alkylreste wie beispielsweise Methyl, Ethyl, Propyl, Butyl, Pentyl, Hexyl, Octyl, Decyl, Dodecyl. Die beiden Alkylreste $R^1$ und $R^2$ haben zusammen vorzugsweise 6 bis 10 C-Atome. Wenn $R^1$ und $R^2$ gemeinsam Alkylen mit 4 bis 8 C-Atomen bedeuten, so ist Butylen, Pentylen oder Hexylen bevorzugt.

Falls R für Alkyl mit 3 bis 18 C-Atomen oder

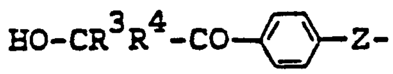

steht, bedeuten $R^1$ und $R^2$ jeweils unverzweigtes oder verzweigtes Alkyl mit 1 bis 6 C-Atomen oder gemeinsam unverzweigtes oder verzweigtes Alkylen mit 2 bis 8 C-Atomen. Bevorzugt sind unverzweigte Alkylreste mit 1 bis 4 C-Atomen, wie Methyl, Ethyl, Propyl, Butyl, insbesondere Methyl. Die beiden Reste $R^1$ und $R^2$ sind vorzugsweise gleich. Wenn $R^1$ und $R^2$ gemeinsam Alkylen bedeuten, so bilden sie zusammen mit dem Kohlenstoffatom an das sie gebunden sind, vorzugsweise einen Cyclopropan-, Cyclobutan-, Cyclopentan-, Cyclohexan- oder Cycloheptanring.

$R^3$ und $R^4$ bedeuten jeweils unverzweigtes oder verzweigtes Alkyl mit 1 bis 6 C-Atomen oder gemeinsam unverzweigtes oder verzweigtes Alkylen mit 2 bis 8 C-Atomen. Dabei sind die im vorstehenden Abschnitt für $R^1$ und $R^2$ genannten bevorzugten Reste auch bei $R^3$ und $R^4$ bevorzugt. Insbesondere sind solche Verbindungen

bevorzugt, in denen der Rest $HO-CR^3R^4-CO-$ gleich dem Rest $HO-CR^1R^4-CO-$ ist.

Z bedeutet -CO-, $-CH_2-$, -O- oder -S-, wobei -CO- und $-CH_2-$ bevorzugt sind.

Dementsprechend werden erfindungsgemäß besonders diejenigen Verbindungen der allgemeinen Formel I bevorzugt, in denen mindestens einer der Reste R, $R_a$, $R^1$ bis $R^4$ und Z eine der vorstehend genannten bevorzugten Bedeutung hat. Beispiele für besonders bevorzugte erfindungsgemäß verwendbare Verbindungen der allgemeinen Formel I sind folgende:

1-Phenyl-2-hydroxy-2, 3-dimethyl-butanon-(1)
1-Phenyl-2-hydroxy-2, 3, 3-trimethyl-butanon-(1)
1-Phenyl-2-hydroxy-2-ethyl-3, 3-dimethyl-butanon-(1)
1-Phenyl-2-hydroxy-2-methyl-hexanon-(1)
1-Phenyl-2-hydroxy-2-ethyl-hexanon-(1)
1-phenyl-2-hydroxy-2-methyl-heptanon-(1)
1-Phenyl-2-hydroxy-2-ethyl-heptanon-(1)
1-Phenyl-2-hydroxy-2-butyl-hexanon-(1)
1-Phenyl-2-hydroxy-2-ethyl-decanon-(1)
1-Benzoyl-cyclopropanol
1-Benzoy-cyclopentanol
1-Benzoyl-cyclohexanol
1-Benzoyl-cycloheptanol
1-(4'-Chlorpbenyl)-2-hydroxy-2-ethyl-hexanon-(1)
1-(4'-Methylphenyl)-2-hydroxy-2-ethyl-hexanon-(1)
1-(3',4'-Dimethylphenyl)-2-hydroxy-2-ethyl-hexanon-(1)
1-(4'-i-Propylphenyl)-2-hydroxy-2-ethyl-hexanon-(1)
1-(4'-tert. Butylphenyl)-2-hydroxy-2-ethyl-hexanon-(1)
1-(4'-Hexylphenyl)-2-hydroxy-2-methyl-propanon-(1)
1-(4'-Octylphenyl)-2-hydroxy-2-methyl-propanon-(1)
1-(4'-Decylphenyl)-2-hydroxy-2-methyl-propanon-(1)
1-(4'-Dodecylphenyl)-2-hydroxy-2-methyl-propanon-(1)
1-(4'-Hexadecylphenyl)-2-hydroxy-2-methyl-propanon-(1)
1-(4'-(2-Ethylhexyl)-phenyl)-2-hydioxy-2-methyl-propanon-(1)
4, 4'-Bis-(2-hydroxy-2-methyl-propanoyl)-benzophenon
4, 4'-Bis-(2-hydroxy-2-ethyl-butanoyl)-benzophenon
4, 4'-Bis-(1-hydroxy-cyclopentyl-carbonyl)-benzophenon
4, 4'-Bis-(1-hydroxy-cyclohexyl-carbonyl)-benzophenon
4, 4'-Bis-(2-hydroxy-2-methyl-propanoyl)-diphenylmethan
4, 4'-Bis-(2-hydroxy-2-methyl-propanoyl)-diphenyloxid
4, 4'-Bis-(2-hydroxy-2-methyl-propanoyl)-diphenylsulfid

Die Herstellung der Verbindungen der allgemeinen Formel I ist aus der DE-OS 27 22 264, der EP-OS 3002 sowie der DE-OS 30 08 411 bekannt. Vorzugsweise arbeitet man nach den dort als bevorzugt genannten Herstellungsverfahren.

Die Verbindungen der allgemeinen Formel I eignen sich erfindungsgemäß als Initiatoren für die Strahlungshärtung wäßriger Prepolymerdispersionen. Diese Verwendung erfolgt in an sich üblicher Weise. Die Hydroxyalkylphenone der allgemeinen Formel I werden den strahlungshärtbaren wäßrigen Systemen in der Regel in Mengen von 0,1 bis 20 Gew.%, vorzugsweise 0,5 bis 10 Gew.%, bezogen auf polymerisierbare Anteile, zugesetzt. Dieser Zusatz geschieht in der Regel durch einfaches Lösen und Einrühren, da die meisten der zu härtenden Systeme und der erfindungsgemäßen Initiatoren flüssig oder zumindest gut löslich sind. Es ist aber auch möglich, den Initiator bereits während der Herstellung der strahlungshärtbaren wäßrigen Prepolymerdispersion einzuarbeiten.

Unter einer strahlungshärtbaren wäßrigen Prepolymerdispersion, die in vielen Variationen im Handel erhältlich sind, wird eine Dispersion aus Wasser und mindestens einem darin dispergierten Prepolymeren sowie gegebenenfalls weiteren bekannten und üblichen Hilfsund Zusatzstoffen verstanden. In diesen Systemen liegt das Wasser in der Regel in einer Konzentration von 5 bis 80, vorzugsweise 30 bis 60 Gew.% vor. Das strahlungshärtbare Prepolymere bzw. Prepolymerengemisch ist dementsprechend in Mengen von 95 bis 20, vorzugsweise 70 bis 40 Gew.% darin enthalten, wobei die Summe der für Wasser und Prepolymere genannten Prozentzahlen jeweils 100 ist und Hilfs- und Zusatzstoffe in je nach Verwendungszweck unterschiedlichen Mengen noch hinzukommen können.

Bei den strahlungshärtbaren, in Wasser dispergierten, oft auch gelösten, filmbildenden Prepolymeren handelt es sich um für wäßrige Prepolymerdispersionen an sich bekannte, durch freie Radikale initiierbare mono- oder polyfunktionelle ethylenisch ungesättigte Prepolymere. Dabei spielen auch die speziellen Anwendungszwecke eine Rolle. Diese Prepolymeren weisen in der Regel einen Gehalt von 0,01 bis 1,0 Mol pro 100 g Prepolymer an polymerisierbaren C-C-Doppelbindungen sowie ein mittleres Molekulargewicht von mindestens 400, in der Regel von 500 bis 10000 auf. Für spezielle Anwendungszwecke kommen jedoch auch Prepolymere mit höheren Molekulargewichten infrage.

Es kommen beispielsweise polymerisierbare C-C-Doppelbindungen enthaltende Polyester mit einer Säurezahl von höchstens 10, polymerisierbare C-C-Doppelbindungen enthaltende Polyether,

hydroxylgruppenbaltige Umsetzungsprodukte aus einem mindestens zwei Epoxidgruppen pro Molekül enthaltenden Polyepoxid mit mindestens einer α,β-ethylenisch ungesättigten Carbonsäure, Polyurethan-(meth-)acrylate sowie α, β-ethylenisch ungesättigte Acylreste enthaltende Acrylcopolymere in Frage, wie sie in der EP-OS 12 339 beschrieben sind. Desgleichen eignen sich auch Gemische dieser Prepolymeren. Weiterhin kommen die in der EP-OS 33 896 beschriebenen polymerisierbaren Prepolymere in Frage, bei denen es sich um Thioetheraddukte von polymerisierbaren Prepolymeren mit einem mittleren Molekulargewicht von mindestens 600, einem Carboxylgruppengehalt von 0,2 bis 15 % und einem Gehalt von 0,01 bis 0,8 Mol polymerisierbarer C-C-Doppelbindungen pro 100 g Prepolymer handelt. Weiterhin eignen sich wäßrige Dispersionen auf Basis von speziellen (Meth)-Acrylsäurealkylester-Polymerisaten mit zwei ausgeprägten, praktisch sich nicht überlappenden Maxima in der Teilchengrößenverteilung, wie sie in der EP-OS 41 125 beschrieben werden. Ferner werden in Wasser dispergierbare, strahlungshärtbare Prepolymere aus Urethanacrylaten in der DE-OS 29 36 039 beschrieben.

Als weitere Zusätze können diese strahlungshärtbaren, wäßrigen Prepolymerdispersionen Dispergierhilfsmittel, Emulgatoren, ferner Antioxidantien, Lichtstabilisatoren, Farbstoffe, Pigmente, Reaktionsbeschleuniger, Füllstoffe sowie andere in der Lacktechnologie übliche Hilfsstoffe enthalten. Als Dispergierhilfsmittel kommen wasserlösliche hochmolekulare organische Verbindungen mit polaren Gruppen, wie z.B. Polyvinylalkohole, Polyvinylpyrrolidon, Celluloseether in Frage. Als Emulgatoren können nichtionische, gegebenfalls auch ionische Emulgatoren verwendet werden. Je nach Verwendungszweck können den strahlungshärtbaren wäßrigen Prepolymerdispersionen in der Lacktechnologie übliche Pigmente und/oder Füllstoffe, wie Talkum, Gips, Kieselsäure, Rutil, Ruß, Zinkoxid, Eisenoxide oder organische Pigmente, außerdem Hilfstoffe, wie Verlaufsmittel, Gleitmittel, Netzmittel, Verdickungsmittel, Mattierungsmittel, Entschäumer zugesetzt werden.

Die Herstellung solcher strahlungshärtbarer wäßriger Prepolymerdispersionen ist bekannt, insbesondere arbeitet man nach den in der Literatur bzw. den bereits genannten Druckschriften angegebenen Verfahren.

Die Hydroxyalkylphenone der allgemeinen Formel I können als Initiatoren bei der Strahlungshärtung von Beschichtungsmitteln für nichtmetallische und metallische Substrate, z.B. für Papier, Holz, Leder, Kunststoffe, Glas, Keramik sowie metallische Untergründe eingesetzt werden. Bevorzugt sind hierbei poröse Substrate, wie beispielsweise Papier, Holz, Leder. Ferner können die Verbindungen der Formel I eingesetzt werden als Initiatoren bei der Strahlungshärtung von solchen wäßrigen Prepolymerdispersionen, die auf Faservliese zu deren Verstärkung aufgezogen werden.

Die Strahlungshärtung des wäßrigen Systems erfolgt nach vollständiger Verdampfung des Wassers bzw. bei Spritzapplikation zusätzlich nach vollständigem Entweichen der eingeschlossenen Luft nach an sich bekannten Methoden. Die Entfernung des Wassers erfolgt im allgemeinen durch kurzes Vorheizen bei Temperaturen bis 10° oder durch kurzzeitige IR-Bestrahlung. Bei porösen Substraten sind meist nur sehr kurze Vorheizzeiten erforderlich, da die Hauptmenge des Wassers vom Untergrund aufgenommen wird; oft kann auf ein Vorheizen auch ganz verzichtet werden. Die anschließende Photopolymerisation erfolgt durch Bestrahlen mit Licht oder UV-Strahlung des Wellenlängenbereichs von 250 bis 500 nm, vorzugsweise von 300 bis 400 nm. Als Strahlenguellen können Sonnenlicht oder künstliche Strahler verwendet werden. Vorteilhaft sind z.B. Quecksilberdampf-Hochdruck-, -Mitteldruck- oder -Niederdrucklampen, Xenon- und Wolframlampen; Laser-Lichtquellen können ebenfalls eingesetzt werden.

In den folgenden Beispielen wird die erfindungsgemäße Verwendung von Hydroxyalkylphenonen der allgemeinen Formel I als Initiatoren bei der Strahlungshärtung wäßriger Prepolymerdispersionen näher beschrieben. Dabei sind Konzentrations- und Prozentangaben, soweit nichts anderes angegeben ist, auf das Gewicht bezogen.

**Beispiel 1**

20 g eines Mattierungsmittels auf Basis Kieselsäure (Mattierungsmittel OK 412 der Firma Degussa, Frankfurt/M.) werden in 166 g einer 50 %igen wäßrigen Emulsion eines ungesättigten Acrylatharzes (Laromer® LR 8576 der Firma BASF AG, Ludwigshafen) dispergiert. Nach einer Standzeit von 18 Stunden werden weitere 166 g der 50 %igen wäßrigen Emulsion des ungesättigten Acrylatharzes und 35,2 g Wasser unter Rühren zugegeben. In jeweils 150 g dieser homogenen wäßrigen Dispersion werden jeweils 1,2 % des entsprechenden Initiators eingerührt. Diese Dispersionen werden in braun eingefärbten Glasflaschen aufbewahrt. Nach einer Standzeit von 24 Stunden werden die mit dem jeweiligen Initiator versetzten wäßrigen Dispersionen mit einem Filmziehgerät in Schichtdicken von 250 µm auf Glasplatten aufgezogen. Die beschichteten Glasplatten werden 20 Minuten lang bei 10° getrocknet. Die anschließende Härtung dieser wasserfreien Beschichtungen erfolgt mit einem Minicure-Gerät (der Fa. Primarc Ltd. (England)), bei dem die beschichteten Glasplatten auf einem Transportband mit variabler Geschwindigkeit unter einer Hg-Mitteldrucklampe (Strahlungsstärke 80 W/cm) im Abstand von 10 cm vorbeibewegt und dabei bestrahlt werden. Durch Änderung der Bandgeschwindigkeit wird die Strahlendosis variiert.

In der folgenden Tabelle I werden die maximalen Bandgeschwindigkeiten (in m/min) angegeben, bei der die jeweilige Beschichtung noch derart ausgehärtet wird, daß deren Oberfläche trocken und klebfrei ist. Die Klebfreiheit wird mit Hilfe eines kleinen, fettfreien Wattebausches nach der in der DE-AS 27 13 797

angegebenen Methode bestimmt. Der gleiche Härtegrad eines mit UV-Strahlung gehärteten Systems wird - unter sonst gleichen Bedingungen - in umso kürzerer Bestrahlungszeit erhalten, je geeigneter der verwendete Initiator ist.

**Tabelle I**

| Verwendeter Photoinitiator | Bandgeschwindigkeit (m/min) |
|---|---|
| 1-(4-Dodecylphenyl)-2-hydroxy-2-methyl-propanon-(1) | 250 |
| 1-Phenyl-2-hydroxy-2-methyl-propanon-(1) (Vergleich) | 50 |

Die Ergebnisse zeigen, daß bei Verwendung des erfindungsgemäßen Initiators mit wesentlich höherer Bandgeschwindigkeit gearbeitet werden kann, d.h. daß in wesentlich kürzerer Zeit eine durchgehärtete Beschichtung mit klebfreier Oberfläche erhalten werden kann.

**Beispiel 2**

Zu 300 g einer 50 %igen wäßrigen Emulsion eines ungesättigten Acrylatharzes (Laromer® LR 8576 der Firma BASF AG, Ludwigshafen) werden unter Rühren 300 g Wasser zugegeben. Anschließend wird noch 30 Minuten nachgerührt. In jeweils 170 g dieser erhaltenen wäßrigen Dispersion werden jeweils 1,275 g des Initiators und jeweils 1,275 g einer 10 %igen, wäßrigen Lösung eines Netzmittels auf Basis eines fluorierten Alkylesters (Fluorad® FC 430 der Firma 3M-Deutschland GmbH, Neuss) eingerührt.

Die mit dem jeweiligen Initiator versetzten wäßrigen Dispersionen werden mit einem Filmziehgerät in Schichtdicken von 120 µm auf Glasplatten aufgebracht.

Die beschichteten Glasplatten werden 10 Minuten lang bei 100° getrocknet. Die anschließende Härtung dieser wasserfreien Beschichtungen erfolgt mit einem Minicure-Gerät (der Fa. Primarc Ltd. (England)), bei dem die beschichteten Glasplatten auf einem Transportband mit variabler Geschwindigkeit unter Hg-Mitteldrucklampen (Strahlungsstärke der Lampen zusammen 120 W/cm) im Abstand von 10 cm vorbeibewegt und dabei bestrahlt werden. Durch Änderung der Bandgeschwindigkeit wird die Strahlendosis variiert.

In der folgenden Tabell 2 werden die maximalen Bandgeschwindigkeiten (in m/min) angegeben, bei der die jeweilige Beschichtung noch derart ausgehärtet wird, daß deren Oberfläche trocken und klebfrei ist. Die Klebfreiheit wird wie in Beispiel 1 angegeben bestimmt.

**Tabelle 2**

| Verwendeter Photoinitiator | Bandgeschwindigkeit (m/min) |
|---|---|
| 1-(4'-Methylphenyl)-2-hydroxy-2-ethyl-hexanon-(1) | 280 |
| 1-Phenyl-2-hydroxy-2-methyl-propanon-(1) (Vergleich) | 60 |

Auch diese Ergebnisse zeigen, daß bei Verwendung eineserfindungsgemäßen Initiators mit wesentlich höherer Bandgeschwindigkeit gearbeitet werden kann, d.h. daß in wesentlich kürzerer Zeit eine durchgehärtete Beschichtung mit klebfreier Oberfläche erhalten werden kann.

**Patentansprüche**

1. Verwendung von Hydroxyalkylphenonen der allgemeinen Formel I

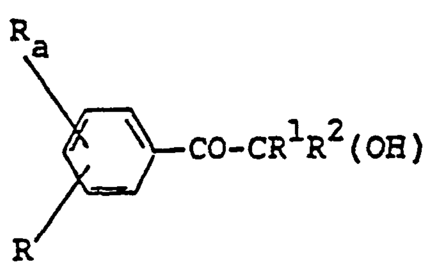

(I)

worin
R Wasserstoff, Halogen, Alkyl mit 1 bis 18 C-Atomen, Alkoxy mit 1 bis 4 C-Atomen oder

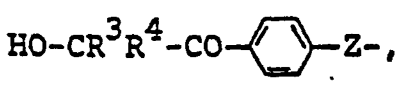

$R_a$ Wasserstoff, Halogen oder Alkyl mit 1 bis 4 C-Atomen,
$R^1$ und $R^2$ (a) jeweils Alkyl mit bis zu 14, zusammen 4 bis 16 C-Atomen oder gemeinsam Alkylen mit 4 bis 8 C-Atomen, falls R Wasserstoff, Halogen, Alkyl mit 1 bis 6 C-Atomen oder Alkoxy mit 1 bis 4 C-Atomen bedeutet, (b) jeweils Alkyl mit 1 bis 6 C-Atomen oder gemeinsam Alkylen mit 2 bis 8 C-Atomen, falls R Alkyl mit 3 bis 18 C-Atomen oder

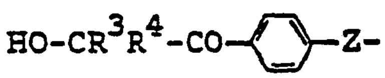 bedeutet,

$R^3$ und $R^4$ jeweils Alkyl mit 1 bis 6 C-Atomen oder gemeinsam Alkylen mit 2 bis 8 C-Atomen und Z -CO-,-$CH_2$-, -O- oder -S bedeuten,
als Initiatoren für die Photopolymerisation ethylenisch ungesättiger Verbindungen, dadurch gekennzeichnet, daß die Initiatoren vor der Photopolymerisation in wäßrige Prepolymerdispersionen eingearbeitet werden.

2. Verfahren zur Photopolymerisation von ethylenisch ungesättigten Verbindungen, dadurch gekennzeichnet, daß man die Initiatoren nach Anspruch 1 in wäßrige Prepolymerdispersionen einarbeitet und nach Entfernungen des Wassers die Polymerisation auslöst.

**Claims**

1. Use of hydroxyalkylphenones of the general formula I

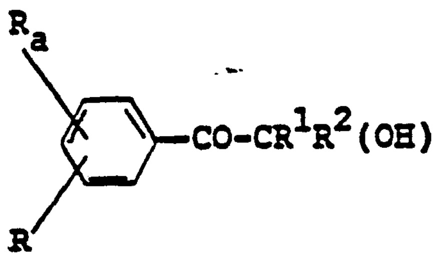

(I)

wherein R is hydrogen, halogen, alkyl having 1 to 18 C atoms, alkoxy having 1 to 4 C atoms or

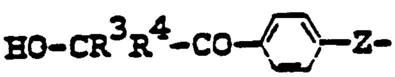,

$R_a$ is hydrogen, halogen or alkyl having 1 to 4 C atoms, $R^1$ and $R^2$ (a) are each alkyl having up to 14, together 4 to 16, C atoms or are together alkylene having 4 to 8 C atoms, if R is hydrogen, halogen, alkyl having 1 to 6 C atoms or alkoxy having 1 to 4 C atoms, or (b) are each alkyl having 1 to 6 C atoms or are together alkylene having 2 to 8 C atoms, if R is alkyl having 3 to 18 C atoms or

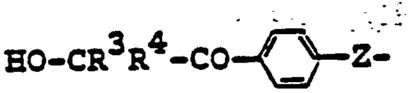 ,

$R^3$ and $R^4$ are each alkyl having 1 to 6 C atoms or are together alkylene having 2 to 8 C atoms and Z is -CO-, -$CH_2$-, -O- or -S-, as initiators for the photopolymerisation of ethylenic unsaturated compounds, characterised in that the initiators are incorporated in aqueous prepolymer dispersions before photopolymerisation.

2. Process for the photopolymerisation of ethylenic unsaturated compounds, characterised in that the initiators according to Claim 1 are incorporated in aqueous prepolymer dispersions and, after removal of the water the polymerisation is initiated.

**Revendications**

1. Application d'hydroxyalcoylphénones de formule générale I

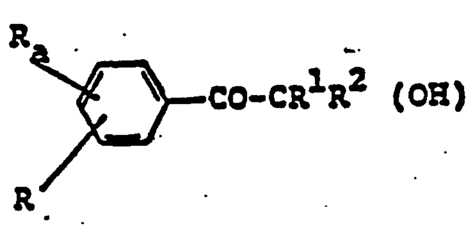

(I)

où

R représente un hydrogène, un halogène, un alcoyle en C1 à C18, un alcoxy en C1 à C4 ou

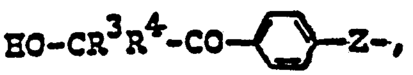

Ra représente un hydrogène, un halogène ou un alcoyle en C1 à C4,

R1 et R2 représentent a) chacun un alcoyle ayant jusqu'à 14, ensemble de 4 à 16, atomes de carbone ou ensemble un alcoylène en C4 à C8, si R représente un hydrogène, un halogène, un alcoyle en C1 à C6 ou un alcoxy en C1 à C4,

b) chacun un alcoyle en C1 à C6 ou ensemble un alcoylène en C2 à C8, si R représente un alcoyle en C3 à C18 ou

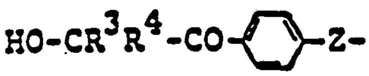

R3 et R4 représentent chacun un alcoyle en C1 à C6 ou ensemble un alcoylène en C2 à C8 et

Z représente -CO-, $-CH_2-$, -O- ou -S-, comme initiateurs pour la photopolymérisation de composés éthyléniquement non saturés, caractérisée en ce qu'on introduit les initiateurs avant la photopolymérisation dan des dispersion aqueuses de prépolymères.

2. Procédé de photopolymérisation de composés éthyléniquement non saturés, caractérisé en ce qu'on introduit les initiateurs selon la revendication 1 dans des dispersions aqueuses de prépolymères et en ce qu'on déclenche la polymérisation après avoir retiré l'eau.